# EUROPÄISCHE PATENTANMELDUNG

(11) **EP 1 184 872 A1**
(43) Veröffentlichungstag der Anmeldung: **06.03.2002**
(21) Anmeldenummer: 01118181.5
(22) Anmeldetag: 27.07.2001
(51) Int. Cl.: G11C 11/4076, G11C 11/4096, G11C 11/4093, G11C 7/10, G11C 7/22

(54) **Verfahren und Vorrichtung zum Speichern und Ausgeben von Daten mit einem virtuellen Kanal**

(30) Priorität: 18.08.2000 DE 10040462
(71) Anmelder: Infineon Technologies AG, 81669 München (DE)
(72) Erfinder: Benedix, Alexander, 81739 München (DE)
(74) Vertreter: Patentanwaltskanzlei WILHELM & BECK

(57) **Zusammenfassung**

Es wird ein Verfahren und eine Vorrichtung zum Ausgeben von Daten über einen Zwischenspeicher beschrieben, bei dem'die Daten ausgewählt werden, die zuerst vom Zwischenspeicher ausgegeben werden sollen. Die ausgewählten Daten werden entweder in einen vorbestimmten Bereich des Zwischenspeicher und/oder zeitlich vor den restlichen Daten in den Zwischenspeicher eingeschrieben und ausgegeben.

## Beschreibung

Verfahren und Vorrichtung zum Speichern und Ausgeben von Daten mit einem virtuellen Kanal

Die Erfindung betrifft ein Verfahren zum Speichern und Ausgeben von Daten gemäß dem Oberbegriff des Patentanspruchs 1 und eine Vorrichtung zum Speichern und Ausgeben von Daten gemäß dem Oberbegriff des Patentanspruchs 5.

Aus der Veröffentlichung "How to use Virtual Channel SDRAM", User's Manuell (M13311EJ1V0UM00), Juli 1998, der Firma NEC sind SDRAM-Speicher bekannt, bei denen Daten eines Segments aus einer Speicherbank in einen Speicherkanal geladen werden. Das Segment wird aus einer festgelegten Reihe der Speicherbank ausgewählt. Nach dem Zwischenspeichern im Speicherkanal werden die Daten über die Vorgabe der Spaltenadresse über eine Schnittstelle ausgegeben. Die Verwendung des Speicherkanals bietet die Möglichkeit, Daten aus einem Speicher mit einer relativ langen Zugriffszeit in einen Zwischenspeicher mit einer kurzen Zugriffszeit zwischenzuspeichern und anschließend auszugeben. Auf diese Weise wird im statistischen Mittel ein schnelleres Auslesen der Daten aus dem Speicher ermöglicht. Da die Daten segmentweise in den Speicherkanal eingelesen werden, wird aufgrund der großen Anzahl der Daten beim Einlesen in den Speicherkanal ein relativ großes Störsignal erzeugt, so dass die Wartezeit relativ lang ist, nach der die bei einem Lesevorgang (im Sense Amp, d.h. nach einem Sensing Vorgang) gelesenen Daten in den Speicherkanal geschrieben werden können. Damit vergrößert sich die Gesamtwartezeit, bis die Daten über die Schnittstelle ausgegeben werden können.

Die Aufgabe der Erfindung besteht darin, ein Verfahren und eine Vorrichtung bereitzustellen, mit der ein schnelleres Ausgeben der Daten über die Schnittstelle möglich ist.

Die Aufgabe der Erfindung wird durch das Verfahren mit den Merkmalen des Anspruchs 1 und durch die Vorrichtung mit den Merkmalen des Anspruchs 5 gelöst.

Vorteilhaft ist es, die Daten, die zuerst über die Schnittstelle ausgegeben werden sollen, auszuwählen und zeitlich zuerst in den Zwischenspeicher einzuschreiben und erst zu einem späteren Zeitpunkt die restlichen Daten des Segments in den Zwischenspeicher einzulesen. Da die zuerst eingelesenen Daten eine sehr viel geringere Anzahl als die Daten des gesamten Segments darstellen, ist auch das durch das Einschreiben in den Zwischenspeicher erzeugte Störsignal deutlich kleiner, so dass nach einer kürzeren Wartezeit die Daten aus dem Zwischenspeicher über die Schnittstelle ausgegeben werden können.

In einer weiteren vorteilhaften Ausführungsform werden die Daten, die zuerst über die Schnittstelle ausgegeben werden sollen, ausgewählt und in einen vorgegebenen Bereich des Zwischenspeichers eingeschrieben. Die restlichen Daten des Segments werden vorzugsweise auch gleichzeitig in einen anderen Bereich des Zwischenspeichers eingeschrieben. Da die ausgewählten Daten eine geringere Anzahl darstellen, ist auch das von den ausgewählten Daten in dem vorgegebenen Bereich des Zwischenspeichers erzeugte Störsignal deutlich niedriger als das von den restlichen Daten des Segments erzeugte Störsignal. Damit können die ausgewählten Daten nach einer kürzeren Wartezeit als die restlichen Daten des Segments über die Schnittstelle ausgegeben werden.

Weitere vorteilhafte Ausführungsformen der Erfindung sind in den abhängigen Ansprüchen angegeben. Vorzugsweise werden aus dem Segment die Anzahl von Daten ausgewählt, die über die Schnittstelle gleichzeitig ausgegeben werden können. Auf diese Weise wird eine effektive Anpassung der ausgewählten Daten an die Ausgabeart der Schnittstelle erreicht.

Die Erfindung wird im folgenden anhand der Figuren näher erläutert. Es zeigen:
- Figur 1: einen schematischen Aufbau der erfindungsgemäßen Vorrichtung zum Speichern und Ausgeben von Daten,
- Figur 2: eine schematische Darstellung des Auslesens von Daten über Speicherkanäle,
- Figur 3: eine Aufteilung der Daten im Speicher und im Speicherkanal,
- Figur 4: den Aufbau von Speicherkanälen mit Schnittstellen unterschiedlicher Bitbreite und
- Figur 5: ein Verfahren zum Ausgeben von ausgewählten Daten.

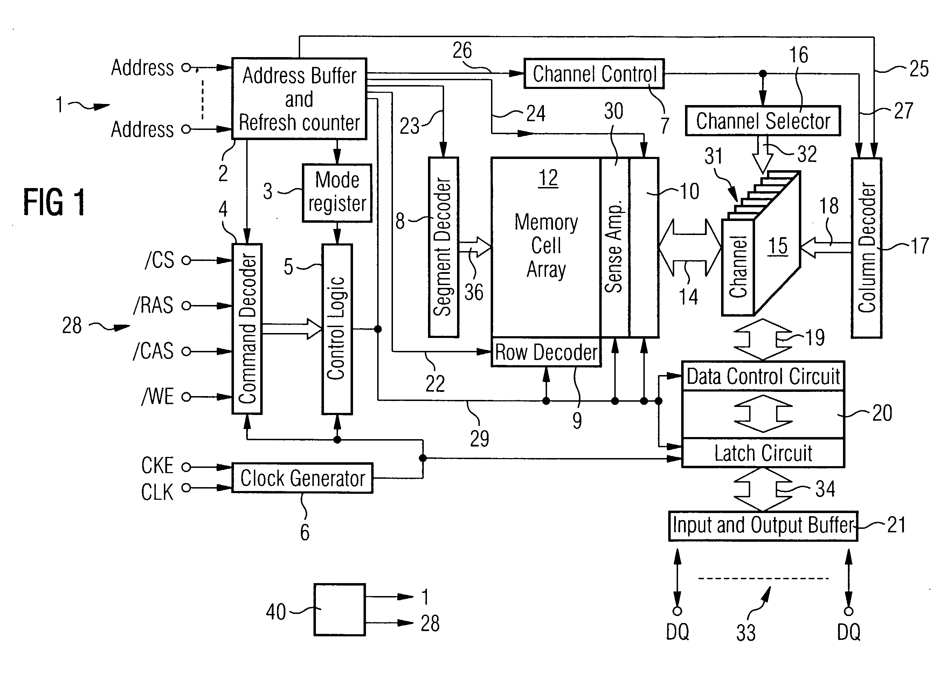

Figur 1 zeigt den schematischen Aufbau eines SDRAM-Speichers, mit einer Speicherbank 12, die als Matrix-Speicher mit Speicherzellen aufgebaut ist. Üblicherweise sind mehrere Speicherbänke vorgesehen, die jedoch nicht explizit dargestellt sind. Die Speicherzellen der Speicherbank 12 sind einzeln über Spaltenleitungen von einem ersten Spaltendekoder 10 und Reihenleitungen von einem Reihendekoder 9 ansteuerbar. Weiterhin ist ein Segmentdekoder 8 vorgesehen, über den eine vorgegebene Anzahl von Speicherzellen einer Reihe ansteuerbar sind. Zur Ansteuerung der Segmente oder der einzelnen Speicherzellen ist ein Adresspuffer 2 vorgesehen, der über eine Reihenleitung 22 mit dem Reihendekoder 9, über eine Segmentleitung 23 mit dem Segmentdekoder 8 und über eine Spaltenleitung 24 mit dem Spaltendekoder 10 verbunden ist. Der Adresspuffer 2 weist Adresseingänge 1 auf, über die die Adressen der auszulesenden Speicherzellen vorgebbar sind.

Der Adresspuffer 2 ist weiterhin über eine zweite Spaltenleitung 25 mit einem zweiten Spaltendekoder 17 verbunden. Weiterhin steht der Adresspuffer 2 über eine Kanalleitung 26 mit einer Kanalsteuerung 7 in Verbindung, die wiederum über zweite Steuerleitungen 27 mit einer Auswahleinrichtung 16 und dem zweiten Spaltendekoder 17 verbunden ist.

Weiterhin ist ein Befehlsdekoder 4 mit Eingängen 28 vorgesehen, der an eine Steuerlogik 5 angeschlossen ist. Zudem steht der Adresspuffer 2 über ein Zustandsregister 3 mit der Steuerlogik 5 in Verbindung.

Die Steuerlogik 5 ist über eine dritte Steuerleitung 29 mit dem Adresspuffer 2, dem Reihendekoder 9, einer Verstärkerschaltung 30, dem ersten Spaltendekoder 10 und einem Ausgabespeicher 20 verbunden. Der Adresspuffer 2 steht zudem mit dem Befehlsdekoder 4 in Verbindung. Weiterhin ist ein Timer 6 vorgesehen, der an den Befehlsdekoder 4, die Steuerlogik 5 und den Ausgabespeicher 20 angeschlossen ist. Zudem ist eine Recheneinheit 40 vorgesehen, die an die Adresseingänge 1 und die Eingänge 28 angeschlossen ist.

Die Verstärkerschaltung 30 ist über Lese- und Schreibleitungen mit den Speicherzellen der Speicherbank 12 verbunden und steht über einen ersten Datenbus 14 mit einem Zwischenspeicher 15 in Verbindung. Der Zwischenspeicher 15 ist in Form von n-Speicherkanälen 31 aufgebaut. Jeder Speicherkanal ist beispielsweise als matrixförmiger RAM-Speicher ausgebildet. Der Zwischenspeicher 15 steht über vierte Steuerleitungen 32 mit der Auswahleinrichtung 16 und über erste Steuerleitungen 18 mit dem zweiten Spaltendekoder 17 und über einen zweiten Datenbus 19 mit dem Ausgabespeicher 20 in Verbindung. Der Ausgabespeicher 20 wiederum steht über einen dritten Datenbus 34 mit einem Ein- und Ausgabespeicher 21 in Verbindung, an den Datenleitungen 33 angelegt sind.

Im folgenden wird kurz die schematische Funktionsweise der Anordnung der Figur 1 erläutert:

Über die Eingänge 28 des Befehlsdekoders 4 werden vorgegebene Signale angelegt, die dem Befehlsdekoder 4 mitteilen, dass Daten aus der Speicherbank 12 in einer vorgegeben Art und Weise ausgegeben werden sollen. Zugleich werden über die Adresseingänge 1 die Speicheradressen der auszulesenden Daten an den Adresspuffer 2 angelegt. Erhält der Befehlsdekoder 4 ein korrektes Befehlsignal über die Eingänge 28, so wird der angelegte Befehl an die Steuerlogik 5 weitergegeben. Die Steuerlogik 5 und der Befehlsdekoder 4 werden vom Timer 6 mit einem vorgegebenen Takt versorgt. Die Steuerlogik 5 steuert entsprechend dem vorgegebenen Befehl den Reihendekoder 9, den ersten Spaltendekoder 10 und die Verstärkerschaltung 30 an.

Der Spaltendekoder 10 ermittelt aus den vom Adresspuffer 2 zugeführten Speicheradressen die Spaltenleitungen, die zum Auslesen der ausgewählten Daten aktiviert werden müssen. Ebenfalls ermittelt der Reihendekoder 9 aufgrund der vom Adresspuffer 2 zugeführten Speicheradressen die Reihenleitungen, die zum Auslesen der ausgewählten Daten aktiviert werden müssen. Erhalten nun der Reihendekoder 9 und der Spaltendekoder 10 ein Ansteuersignal von der Steuerlogik 5, so werden die ausgewählten Spalten und Reihenleitungen aktiviert und dadurch die Daten der ausgewählten Speicherzellen an die Verstärkerschaltung 30 übergeben. Die Verstärkerschaltung 30 verstärkt die aus den ausgewählten Speicherzellen zugeführten Signale und gibt diese über den ersten Datenbus 14 an den Zwischenspeicher 15 weiter. Im Zwischenspeicher 15 werden die Signale der ausgelesenen Speicherzellen in einem ausgewählten Speicherkanal 31 abgelegt. Der Speicherkanal 31 wird von der Auswahleinrichtung 16 ausgewählt, die wiederum vom Adresspuffer 2 über die Kanalsteuerung 7 angesteuert wird.

Die im Speicherkanal 31 abgelegten Daten werden durch eine Ansteuerung des zweiten Spaltendekoders 17 aus dem durch die Auswahleinrichtung 16 festgelegten Speicherkanal 31 ausgelesen und über den zweiten Datenbus 19 zu einem Ausgabespeicher 20 übertragen. Der Ausgabespeicher 20 gibt nach einem entsprechenden Steuerbefehl durch die Steuerlogik 5 die gespeicherten Daten über einen dritten Datenbus 34 an den Ein-/Ausgabespeicher 21 weiter, an den die Datenleitungen 33 angeschlossen sind. Somit liegen die Daten an den Datenleitungen 33 an und können abgefragt werden.

Wird nun dem Befehlsdekoder 4 über die Eingänge 28 der Befehl zugeführt, dass Daten eines vorgegeben Segments ausgelesen werden sollen, so erhält die Steuerlogik 5 den Befehl Daten des vorgegebenen Segments auszulesen. Gleichzeitig werden an die Adresseingänge 1 die Adressen des ausgelesenen Segments an den Adresspuffer 2 gegeben. Der Adresspuffer 2 gibt die Adressen an den Segmentdekoder 8 weiter, der wiederum über fünfte Steuerleitungen 36 das auszulesende Segment aktiviert. Gleichzeitig gibt die Steuerlogik 5 an den Reihendekoder 9 das Signal, die Reihe des entsprechenden Segments zu aktivieren und gibt an die Verstärkerschaltung 30 das Signal, die Daten auszulesen. Daraufhin werden die Daten des ausgewählten Segments über die Verstärkerschaltung 30 an einen durch die Auswahleinrichtung 16 festgelegten Speicherkanal 31 ausgelesen. Bei dieser Ausleseart wird der erste Spaltendekoder 10 nicht angesteuert, da die Daten eines ganzen Segments ausgelesen werden.

Der Speicherkanal 31 wird über die Auswahleinrichtung 16 ausgewählt. Zum Auslesen der Daten aus dem Speicherkanal 31 wird über den Spaltendekoder 17 ein Auslesesignal an den Speicherkanal 31 gegeben. Zudem gibt die Steuerlogik 5 ein Auslesesignal an den Ausgabespeicher 20, der die im ausgewählten Speicherkanal 31 abgelegten Daten über den zweiten Datenbus 19 ausliest und zu einem späteren Zeitpunkt über den dritten Datenbus 34 an den Ein/Ausgabespeicher 21 ausgibt.

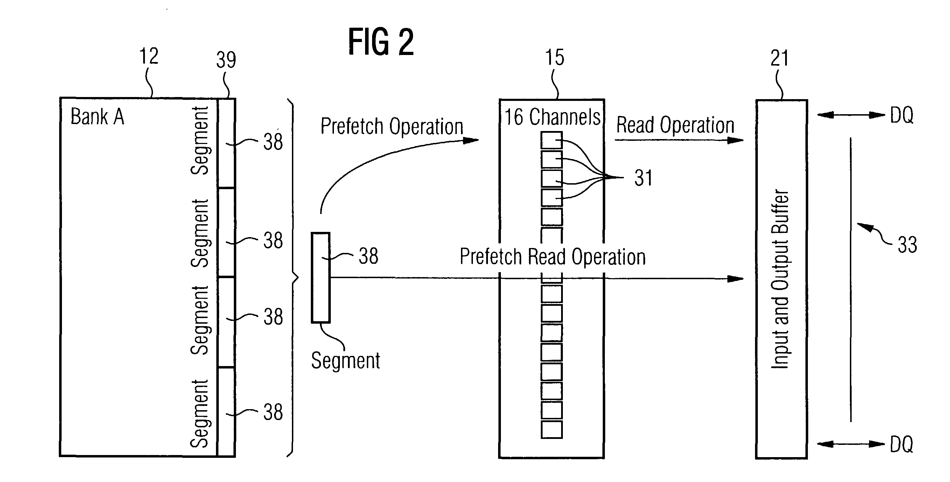

Figur 2 zeigt schematisch eine Darstellung, die das Auslesen von Daten eines Segments der Speicherbank 12 über die Speicherkanäle 31 erläutert. Die Speicherbank 12 ist in vier Segmente 38 je Reihe 39 eingeteilt. Über den Segmentdekoder 8 kann eines der vier Segmente 38 ausgewählt werden. Gleichzeitig kann über den Reihendekoder 9 eine Reihe und damit ein einziges Segment ausgewählt werden. Liegt nun über dem Segmentdekoder 8 und dem Reihendekoder 9 ein entsprechendes Signal an der Speicherbank 12 an, so werden die Speicherzellen eines ausgewählten Segments, die sich auf einer Reihe befinden, aktiviert. Gleichzeitig wird von der Steuerlogik 5 die Verstärkerschaltung 30 aktiviert, so dass die Daten des ausgewählten Segments in einen der Speicherkanäle 31 eingeschrieben werden. Die Auswahl des Speicherkanals 31 erfolgt über die Auswahleinrichtung 16. Anschließend werden die im Speicherkanal 31 abgelegten Daten des Segments zu einem späteren Zeitpunkt an den Ein/Ausgabespeicher 21 ausgelesen.

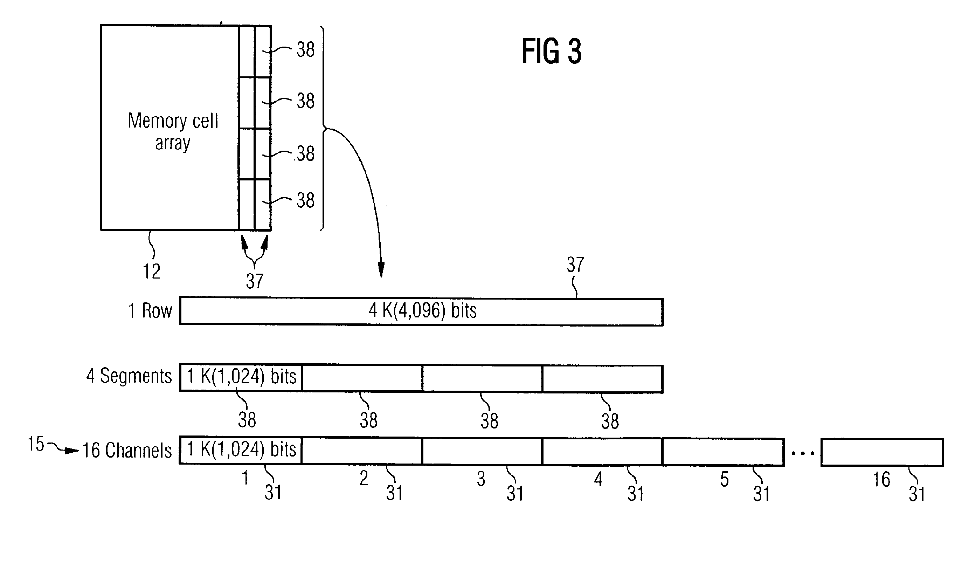

Figur 3 zeigt die Aufteilung der Speicherbank 12 in Reihen 37, wobei die einzelnen Reihen in Segmente 38 unterteilt sind. Eine Reihe 37 ist in vier Segmente 38 unterteilt. In der dargestellten Ausführungsform weist eine Reihe eine Speicherkapazität von 4Kb auf. Damit weist ein Segment eine Speicherkapazität von 1Kb auf.

Vorzugsweise sind im Zwischenspeicher 15 sechzehn Speicherkanäle 31 vorgesehen, wobei jeder Speicherkanal 31 eine Speicherkapazität von 1Kb aufweist.

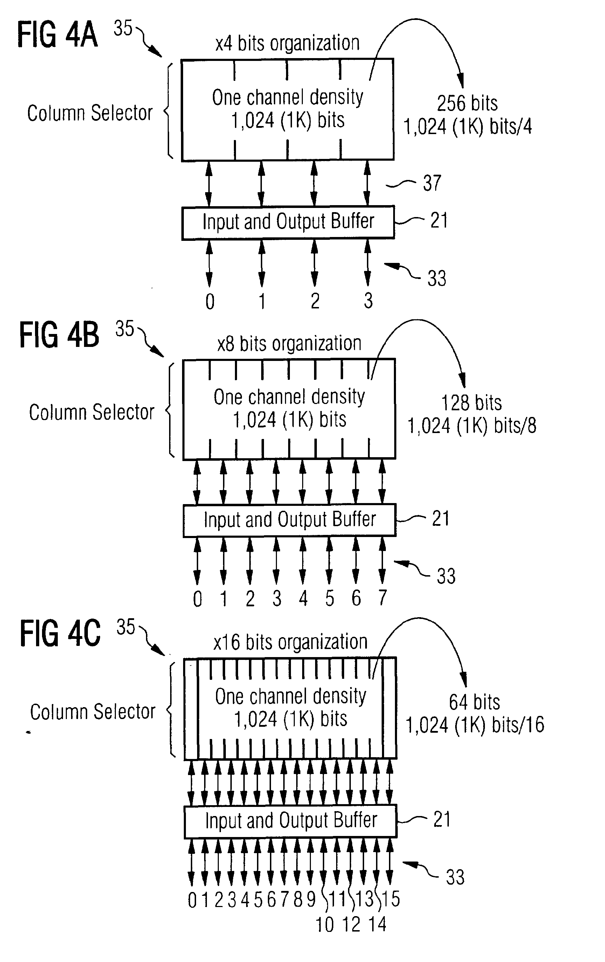

Figur 4 zeigt den Aufbau verschiedener Speicherkanäle 31, die in Form von Matrix-Speichern ausgebildet sind und sich in der Anzahl der Reihen 39 unterscheiden. Figur 4A zeigt einen Matrix-Speicher mit vier Reihen 37, wobei in jeder Reihe 37 256 Bits abgelegt sind. Die Reihen 37 sind mit einem Ein/Ausgabespeicher 21 verbunden, der ebenfalls vier Speicherplätze aufweist, die gleichzeitig über Datenleitungen 33 ein- oder ausgelesen werden können.

Die einzelnen Daten des Speicherkanals 31 werden parallel über die vier Reihen 37 ausgelesen, wobei das auszulesende Datum durch die Vorgabe der entsprechenden Spaltenadresse festgelegt wird, wobei die Spaltenadresse durch den zweiten Spaltendekoder 17 eingestellt wird.

Figur 4B zeigt einen Speicherkanal 31 in Form eines Matrix-Speichers, der acht Reihen 37 aufweist. In einer Reihe 37 sind 128 Bits abgelegt, die einzeln über die Vorgabe der Spaltenadresse ausgebbar sind. In dieser Ausführungsform werden acht Bits gleichzeitig an den Ein/Ausgabespeicher 21 ausgegeben, der über acht Datenleitungen 33 verfügt.

Figur 4C zeigt eine weitere Ausführungsform eines Speicherkanals 31, der sechzehn Reihen 37 aufweist. In den sechzehn Reihen 37 sind jeweils 64 Bits abgespeichert, die über eine Vorgabe der entsprechenden Spaltenadresse ausgebbar sind. In Figur 4C werden sechzehn Daten parallel aus jeweils einer Reihe 39 an den Ein/Ausgabespeicher 21 ausgegeben, der über sechzehn Datenleitungen 33 verfügt.

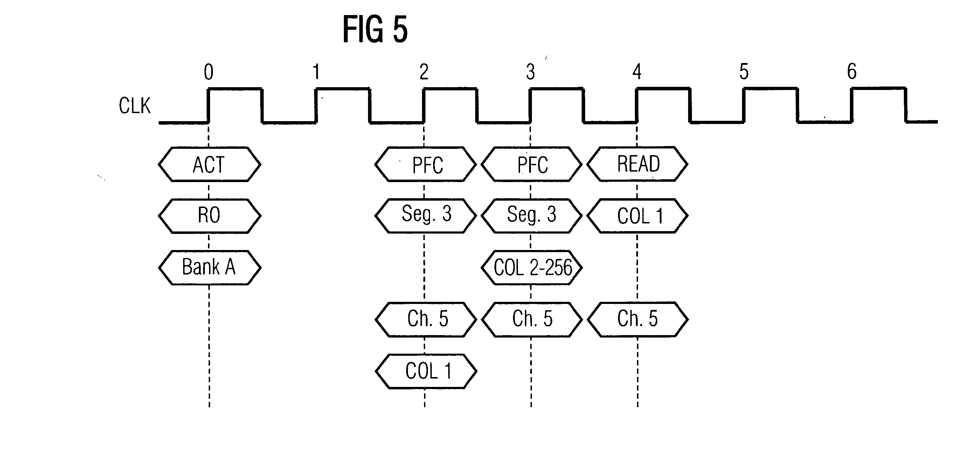

Figur 5 zeigt schematisch den Aufbau des erfindungsgemäßen Verfahrens, bei dem die ausgewählten Daten, die zuerst über die Datenleitungen 33 ausgegeben werden sollen, festgelegt werden und entweder zuerst in einem Speicherkanal 31 eingeschrieben werden und anschließend die restlichen Daten des ausgewählten Segments in den Speicherkanal 31 eingeschrieben werden oder die restlichen Daten des ausgewählten Segments in einen anderen Speicherkanal 31 eingeschrieben werden. Da die Anzahl der ausgewählten Daten, die in einen Speicherkanal 31 eingeschrieben werden, relativ niedrig ist, ist auch das durch das Einschreiben erzeugte Störsignal relativ niedrig.

Im oberen Bereich der Figur 5 ist mit CLK die Zeitbasis angegeben, die vom Timer 6 vorgegeben ist. Zum Zeittakt 0 werden über die Eingänge 28 ein Aktivierungsbefehl ACT an den Befehlsdekoder 4 und die Adressen der auszulesenden Daten an die Adresseingänge 1 des Adresspuffers 2 angelegt. Dabei wird in dem beschriebenen Ausführungsbeispiel von der Steuerlogik 5 mittels des Reihendekoders 9 die Reihe R0 der Speicherbank A geöffnet. Sind mehrere Speicherbänke vorgesehen, so wird ein Bankdekoder verwendet, um die zu öffnende Speicherbank festzulegen. Zugleich wird die Verstärkerschaltung 30 der Reihe R0 aktiviert.

Zum Zeittakt 2 wird ein Prefetch-Befehl ausgeführt, bei dem der Adresspuffer 2 die Adressen des dritten Segments (Seg 3), die Spaltenadressen der ausgewählten Daten (COL1) der Reihe R0 und die Adresse des fünften Speicherkanals (CH5) an den Segmentdekoder 8, die Auswahleinrichtung 16 und den ersten Spaltendekoder 10 gibt. In diesem Ausführungsbeispiel werden als ausgewählte Daten die Daten der ersten Spalte (COL1) verwendet. Gleichzeitig wird von der Steuerlogik 5 ein Signal an die Verstärkerschaltung 30 gegeben, das ein Auslesen der ausgewählten Daten der ersten Spalte (COL1) und der Reihe R0 des dritten Segmentes in den fünften Speicherkanal 31 startet. Dabei wird über die Auswahleinrichtung 16 eine erste Spalte des fünften Speicherkanals 31 ausgewählt, in den die ausgewählten Daten eingeschrieben werden. Auf diese Weise werden die ausgewählten Daten in den fünften Speicherkanal 31 eingeschrieben.

Zum Zeittakt 3 erfolgt intern, d.h. ohne Steuerung von außen, ein Prefetch-Befehl, bei dem die Spaltenadressen der Reihe 0 des dritten Segmentes, die nicht zu den ausgewählten Daten gehören, die sogenannten übrigen Daten (COL 2 - COL 256), bei einem x4 Baustein der Reihe R0 an den ersten Spaltendekoder 10 angelegt werden. In diesem Ausführungsbeispiel werden die Daten der 2. bis 256. Spalte der Reihe R0 adressiert. Die übrigen Daten werden anschließend in entsprechende Spalten des fünften Speicherkanals übertragen. Der Prefetch-Befehl zum Zeittakt 3 ist durch den Prefetch-Befehl zum Zeittakt 2 verursacht.

Die ausgewählten Daten der ersten Spalte (COL1) können zu dem Zeittakt 4 über einen Read Befehl, bei dem eine entsprechende Adressierung des fünften Speicherkanals 31 (CH 5) und Ansteuerung des Ausgabespeichers 20 erfolgt, aus dem fünften Speicherkanal 31 ausgelesen und über den Ein/Ausgabespeicher 21 an die Datenleitungen 33 ausgegeben werden.

Die übrigen Daten der 2. bis 256. Spalte des fünften Speicherkanals können zu einem späteren Zeittakt über einen Read Befehl, bei dem eine entsprechende Adressierung der 2. bis 256. Spalte des fünften Speicherkanals 31 und Ansteuerung des Ausgabespeichers 20 erfolgt, ausgelesen und über den Ein/Ausgabespeicher 21 an die Datenleitungen 33 ausgegeben werden.

Vorzugsweise werden so viele Daten als ausgewählte Daten bestimmt, wie der Ein/Ausgabespeicher 21 Datenleitungen 33 aufweist. Dass heißt, dass bei sechzehn Datenleitungen 33 auch sechzehn Daten als ausgewählte Daten ausgewählt werden und zuerst in einen Speicherkanal 31 und/oder in einen getrennten Speicherkanal 31 ausgelesen werden.

Durch die Verwendung des erfindungsgemäßen Verfahrens ist es möglich, Daten individuell vor dem Auslesen aus der Verstärkerschaltung 30 in den Zwischenspeicher 15 auszuwählen und vor anderen Daten zuerst in den Zwischenspeicher 15 einzulesen. Dadurch wird ein geringeres Störsignal erzeugt, so dass die Daten aus dem Zwischenspeicher 15 schneller wieder ausgelesen werden können, da die Signalpegel sich im Zwischenspeicher schneller auf ein zuverlässliches Niveau einpegeln.

Beispielsweise ist es im Vergleich zu bekannten Burstausleseverfahren, bei denen die Daten Column für Column beginnend mit einer Startcolumn ausgelesen werden, möglich, die Daten einer ausgewählten Column über die Auswahl der Column auszuwählen und die Daten zuerst unabhängig von der Position der Column innerhalb des Burstvorganges in den Zwischenspeicher auszulesen. Beispielsweise werden die Daten einer Column, die sich innerhalb eines normalen Burstauslesevorganges in der Mitte der Reihenfolge der auszulesenden Columns befindet, zuerst ausgelesen werden. Anschliessend wird normaler Burstauslesevorgang durchgeführt, wobei mit dem Auslesen der Daten der Startcolumn gestartet wird. Dabei werden dann die Daten der bereits ausgelesenen Column vorzugsweise nicht noch einmal ausgelesen.

## Patentansprüche

1. Verfahren zum Speichern und Ausgeben von Daten, bei dem Daten in einem Speicher (12) gespeichert werden, bei dem eine vorgegebene Menge der Daten aus dem Speicher (12) in einen Zwischenspeicher (15) geladen werden,
wobei die Daten anschließend aus dem Zwischenspeicher (15) über eine Ausgabeeinheit (19, 20, 21) ausgegeben werden,
**dadurch gekennzeichnet,**
**dass** eine vorgegebene Anzahl von ausgewählten Daten der vorgegebenen Menge bestimmt wird, die zuerst über die Ausgabeeinheit (19, 20,21) ausgegeben werden soll, dass die ausgewählten Daten zeitlich vor den übrigen Daten der vorgegebenen Menge in den Zwischenspeicher (15) geladen werden,
**dass** die ausgewählten Daten zuerst aus dem Zwischenspeicher (15) ausgegeben werden.

2. Verfahren nach Anspruch 1 , **dadurch gekennzeichnet, dass** der Speicher (12) als Halbleiterspeicher in Form von Speicherzellen ausgebildet ist, dass die Daten der Speicherzellen über eine Verstärkungsschaltung (30) in den Zwischenspeicher (15) geladen werden.

3. Verfahren nach einem der Ansprüche 1 oder 2, **dadurch gekennzeichnet, dass** die Daten über eine parallele Schnittstelle (20, 21) mit n-Leitungen (33) ausgegeben werden, und dass n Daten als ausgewählte Daten zeitlich zuerst in den Zwischenspeicher (15) übertragen und anschließend über die Schnittstelle (20, 21) ausgegeben werden.

4. Verfahren nach einem der Ansprüche 1 bis 3, **dadurch gekennzeichnet, dass** die übrigen Daten zeitlich später in den Zwischenspeicher als die vorgegebene Anzahl der ausgewählten Daten eingeschrieben werden.

5. Vorrichtung zum Speichern und Auslesen von Daten mit einem Speicher (12), mit einem Zwischenspeicher (15), mit einer Ausgabeeinheit (19, 20, 34, 21), mit einer Steuereinheit (2, 5),
wobei die Steuereinheit (2, 5) eine Menge von Daten festlegt, die ausgelesen werden sollen,
wobei die Steuereinheit (2, 5) die festgelegte Menge von Daten von dem Speicher (12) in den Zwischenspeicher (15) lädt und anschließend über die Ausgabeeinheit (19, 20, 34, 21) ausliest,
**dadurch gekennzeichnet,**
**dass** die Steuereinheit (2, 5) eine vorgegebene Anzahl von ausgewählten Daten ermittelt, die zuerst ausgelesen werden sollen,
**dass** die Steuereinheit (2, 5) zuerst die ausgewählten Daten in den Zwischenspeicher (15) lädt und anschließend über die Ausgabeeinheit (19, 20, 34, 21) ausgibt.

6. Vorrichtung nach Anspruch 5, **dadurch gekennzeichnet, dass** die Steuereinheit (2, 5) die übrigen Daten der festgelegten Menge vor dem Ausgeben der ausgewählten Daten aus dem Zwischenspeicher (15) in den Zwischenspeicher (15) lädt und nach dem Ausgeben der ausgewählten Daten aus dem Zwischenspeicher (15) ausgibt.

7. Vorrichtung nach Anspruch 5 oder 6, **dadurch gekennzeichnet, dass** der Speicher (12) als matrixförmiger Halbleiterspeicher mit Speicherzellen ausgebildet ist,
dass eine Verstärkerschaltung (30) vorgesehen ist, die mit den Speicherzellen und dem Zwischenspeicher (15) in Verbindung steht,
dass ein Spaltendekoder (10) und ein Reihendekoder (9) vorgesehen sind, die mit den Speicherzellen und der Steuereinheit (2, 5) verbunden sind, und
dass die Steuereinheit (2, 5) über eine Ansteuerung des Spalten- und Reihendekoders (10, 9) einzelne Speicherzellen adressiert und das Datum der Speicherzelle über die Verstärkerschaltung (30) zum Zwischenspeicher (15) überträgt.

8. Vorrichtung nach einem der Ansprüche 5 bis 7, **dadurch gekennzeichnet, dass** die Ausgabeeinheit (19, 20, 34, 21) als Schnittstelle mit n-parallelen Datenleitungen (33) ausgebildet ist,
dass die Datenleitungen (33) an Speicherreihen (37) des Zwischenspeichers (15) angeschlossen sind,
die gleichzeitig aus dem Zwischenspeicher (15) auslesbar sind.
